(19) Europäisches Patentamt

European Patent Office

Office européen des brevets

(11) **EP 0 877 946 B1**

(12) **EUROPÄISCHE PATENTSCHRIFT**

(45) Veröffentlichungstag und Bekanntmachung des Hinweises auf die Patenterteilung:
**14.08.2002 Patentblatt 2002/33**

(21) Anmeldenummer: **97907028.1**

(22) Anmeldetag: **24.01.1997**

(51) Int Cl.⁷: **G01R 31/08**, G01R 19/25

(86) Internationale Anmeldenummer:
**PCT/DE97/00160**

(87) Internationale Veröffentlichungsnummer:
**WO 97/28453 (07.08.1997 Gazette 1997/34)**

(54) **VERFAHREN ZUM ERFASSEN EINER SPRUNGHAFTEN ÄNDERUNG EINER ELEKTRISCHEN WECHSELGRÖSSE**

METHOD OF DETECTING AN ABRUPT VARIATION IN AN ELECTRICAL ALTERNATING QUANTITY

PROCEDE DE DETECTION D'UNE VARIATION SUBITE D'UNE GRANDEUR ALTERNATIVE ELECTRIQUE

(84) Benannte Vertragsstaaten:
**DE FR GB IT**

(30) Priorität: **31.01.1996 DE 19605023**

(43) Veröffentlichungstag der Anmeldung:
**18.11.1998 Patentblatt 1998/47**

(73) Patentinhaber: **SIEMENS AKTIENGESELLSCHAFT**
**80333 München (DE)**

(72) Erfinder: **JURISCH, Andreas**
**D-13587 Berlin (DE)**

(56) Entgegenhaltungen:
**EP-A- 0 224 749**    **EP-A- 0 284 546**

**Beschreibung**

Die Erfindung bezieht sich auf ein Verfahren zum Erfassen einer sprunghaften Änderung einer elektrischen Wechselgröße, bei dem aus abgetasteten Werten der Wechselgröße ein Kriterium für das Auftreten der sprunghaften Änderung gebildet wird. Ein solches Verfahren wird beispielsweise in der Netzschutztechnik eingesetzt, um das Auftreten z.B. eines Kurzschlusses in einem elektrischen Energieversorgungsnetz zu erfassen.

Bei einem bekannten Verfahren dieser Art (angewendet beim Digitalen Abzweigschutz 7SA511 der Siemens AG) wird eine sprunghafte Änderung einer elektrischen Wechselgröße dadurch erfaßt, daß zwei um eine Periode der elektrischen Wechselgröße auseinanderliegende Abtastwerte der Wechselgröße miteinander verglichen werden. Ist die Abweichung Null, dann liegt keine sprunghafte Änderung der Wechselgröße vor, während bei einer Abweichung ungleich Null eine derartige Änderung vorliegen kann. Der Wert Null der Abweichung ist bei dem bekannten Verfahren jedoch trotz gleichmäßig, also ohne sprunghafte Änderung verlaufender Wechselgröße nur dann zu erreichen, wenn die Wechselgröße keine Signale mit von ihrer Nennfrequenz abweichenden Frequenzen aufweist. Ist dies der Fall, dann besteht bei dem bekannten Verfahren immer die Gefahr, daß ein instationärer Vorgang erkannt wird, obwohl eine sprunghafte Änderung überhaupt nicht vorliegt. Um Fehlerfassungen zu vermeiden, wird bei dem bekannten Verfahren ein Schwellenwert so hoch eingestellt, daß bei üblichen Abweichungen der elektrischen Wechselgröße von der Nennfrequenz kein Fehlansprechen auftritt. Dies wiederum hat zur Folge, daß mit dem bekannten Verfahren das Auftreten von sprunghaften Änderungen einer Wechselgröße nur dann erfaßt werden kann, wenn die Änderung groß ist.

Der Erfindung liegt daher die Aufgabe zugrunde, ein Verfahren zum Erfassen einer sprunghaften Änderung einer elektrischen Wechselgröße vorzuschlagen, mit dem sich eine solche Änderung zuverlässig auch dann erfassen läßt, wenn die sprunghafte Änderung relativ klein sind.

Zur Lösung dieser Aufgabe wird bei einem Verfahren der eingangs angegebenen Art erfindungsgemäß die Wechselgröße in einem FIR-Filter mit einer Übertragungsfunktion bewertet, die bei der Nennfrequenz nicht nur selbst, sondern auch mit ihrer ersten Ableitung nach der Zeit den Wert Null als doppelte Nullstelle hat, und das Ausgangssignal des FIR-Filters wird dahingehend überwacht, ob es einen das Auftreten einer sprunghaften Änderung der Wechselgröße angebenden Schwellenwert erreicht.

Der wesentliche Vorteil des erfindungsgemäßen Verfahrens besteht darin, daß aufgrund der Verwendung eines FIR-Filters mit doppelter Nullstelle bei der Nennfrequenz das FIR-Filter bei in vorliegendem Zusammenhang besonders kritischen Wechselgrößen mit relativ geringer Abweichung von der Nennfrequenz ein Ausgangssignal mit einem wesentlich kleineren Wert als mit dem bekannten Verfahren liefert. Die erreichbare Ansprechempfindlichkeit ist bei dem erfindungsgemäßen Verfahren daher wesentlich größer als bei dem bekannten Verfahren.

Bei einer vorteilhaften Ausführungsform des erfindungsgemäßen Verfahrens wird ein FIR-Filter mit einer Übertragungsfunktion mit einer zusätzlichen Nullstelle bei dem Frequenzwert Null verwendet. Dadurch lassen sich zur weiteren Steigerung der Zuverlässigkeit des erfindungsgemäßen Verfahrens Auswirkungen von Offset-Erscheinungen durch eine der Abtastung folgende Analog-Digital-Wandlung auf das Meßergebnis vermeiden.

Bei einer vorteilhaften Schaltungsanordnung zur Durchführung des erfindungsgemäßen Verfahrens ist an das eingangsseitig mit der Wechselgröße beaufschlagte FIR-Filter ausgangsseitig ein Komparator angeschlossen, der bei einem den Schwellenwert erreichenden Ausgangssignal des FIR-Filters ein die sprunghafte Änderung der Wechselgröße kennzeichnendes Signal abgibt. Es ist aber auch ohne weiteres möglich, sowohl das FIR-Filter als auch den Komparator durch eine Datenverarbeitungseinrichtung zu bilden und das erfindungsgemäße Verfahren mittels allein der Datenverarbeitungseinrichtung ablaufen zu lassen, wenn diese auch die Abtastung und Analog-Digital-Wandlung der zu überwachenden elektrischen Wechselgröße durchführt.

Zur Erläuterung der Erfindung ist in

Figur 1     in Form eines Blockschaltbildes ein Ausführungsbeispiel einer Anordnung zur Durchführung des erfindungsgemäßen Verfahrens und in

Figur 2     die Übertragungsfunktion des bei dem Ausführungsbeispiel nach Figur 1 eingesetzten FIR-Filters dargestellt.

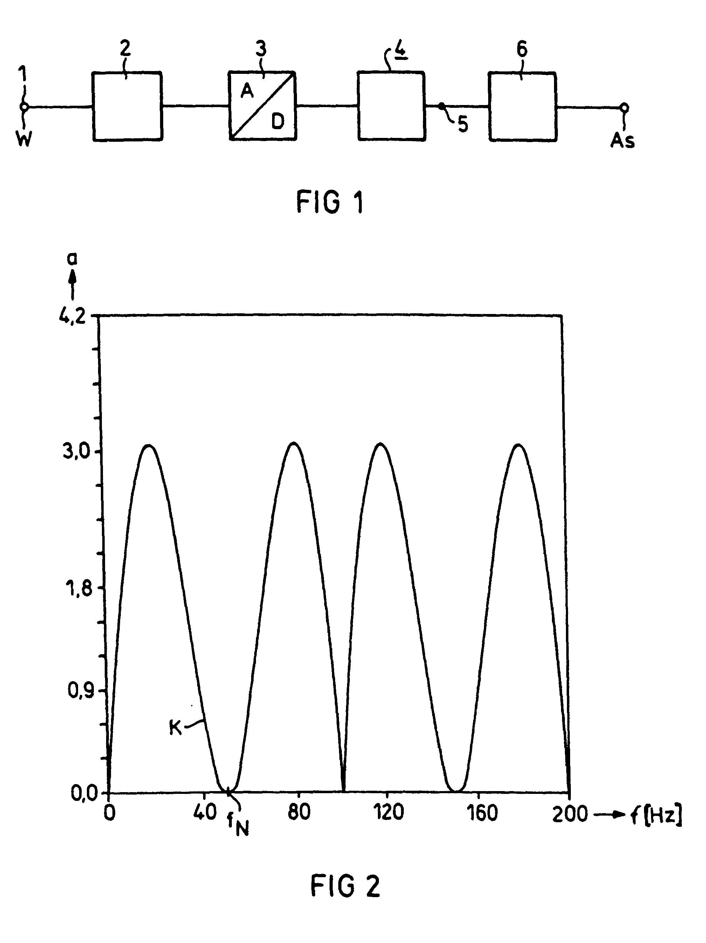

Der Anordnung nach Figur 1 wird an einem Eingang 1 eine elektrische Wechselgröße W zugeführt, bei der es sich beispielsweise um die Spannung an einem zu überwachenden Leitungsabschnitt einer elektrischen Energieversorgungsleitung handeln kann. Tritt auf dem zu überwachenden Leitungsabschnitt ein Fehler, beispielsweise ein Kurzschluß auf, dann verändert die Spannung sprunghaft ihren Verlauf, woraus auf das Auftreten eines Fehlers geschlossen werden kann.

Zur Erfassung von sprunghaften Änderungen der elektrischen Wechselgröße W wird diese in einer Abtasteinrichtung 2, die vorteilhafterweise als Abtast-Halte-Schaltung ausgebildet ist, abgetastet, und zwar in jeder halben Periode der elektrischen Wechselgröße W einmal. Die so gewonnenen Abtastwerte werden in einem nachgeordneten Analog-Digital-Wandler 3 in digitale Werte umgesetzt, die einem nachgeschalteten FIR-Filter 4 zugeführt werden. Das FIR-Filter 4 hat eine Übertragungsfunktion, wie sie in der Figur 2 dargestellt ist.

In der Figur 2 ist über der Frequenz in Hz der Übertragungsfaktor a wiedergegeben; die dargestellte Kurve K gibt den Verlauf der Übertragungsfunktion des FIR-Filters 4 wieder. Es ist zu erkennen, daß im Bereich der Nennfrequenz $f_N$ der zu erfassenden elektrischen Wechselgröße - bei einem Energieversorgungsnetz in der Regel 50 Hz - , die Kurve K einen abgerundeten Verlauf aufweist. Dies ist darauf zurückzuführen, daß die Übertragungsfunktion so bemessen ist, daß sie bei der Nennfrequenz $f_N$ den Wert Null aufweist und darüber hinaus auch hinsichtlich ihrer zeitlichen Ableitung den Wert Null besitzt. Dies führt in vorteilhafter Weise dazu, daß bei Frequenzschwankungen der zu überwachenden elektrischen Wechselgröße W um die Nennfrequenz $f_N$ am Ausgang 5 des FIR-Filters ein Signal mit nur sehr kleinem Wert auftritt, das unterhalb des Schwellenwertes liegt. Eine weitere doppelte Nullstelle weist das FIR-Filter 4 bei 150 Hz auf, weil diese Frequenz als zweite häufig stark ausgeprägte Oberwelle ebenfalls die Messung stören könnte.

Infolge einer sprunghaften Änderung der Wechselgröße W gebildete Komponenten verschiedener Frequenzen werden dagegen gut erfaßt, und es wird somit bei einer sprunghaften Änderung am Ausgang 5 des FIR-Filters 4 ein Signal gebildet, das eine eindeutige Aussage über das Auftreten einer sprunghaften Änderung der Wechselgröße W zuläßt, weil dieses Signal größer als der Schwellenwert ist.

Ein dem FIR-Filter 4 nachgeordneter Komparator 6 kann daher auf einen relativ niedrigen Schwellenwert eingestellt werden, so daß am Ausgang des Komparators 6 unter Erzielung einer hohen Ansprechempfindlichkeit ein Ausgangssignal As immer nur dann auftritt, wenn die elektrische Wechselgröße W eine sprunghafte Änderung erfahren hat.

Das FIR-Filter 4 kann beispielsweise mit folgender Übertragungsfunktion a(Z) beschrieben werden:

$$a(Z) = 1 + Z^{-1} - Z^{-2} - Z^{-3} \qquad (1),$$

in der Z den komplexen Operator $Z = e^{j\varpi \cdot t_a}$ angibt mit $t_a$ = 10ms als Abtastintervall gemäß obigem Beispiel. Aus Gleichung (1) folgt ohne weiteres mit $Z = e^{j\varpi \cdot t_a}$ die Beziehung (2)

$$K(j\omega) = 1 + I^{-1j\omega t_a} - I^{-j2\omega t_a} - I^{-j3\omega t_a} \qquad (2).$$

Diese Gleichung (2) gibt den komplexen Übertragungsfaktor im Frequenzbereich wieder. Der Betrag a dieses Faktors ist in Fig. 2 dargestellt.

**Patentansprüche**

1. Verfahren zum Erfassen einer sprunghaften Änderung einer elektrischen Wechselgröße, bei dem aus abgetasteten Werten der Wechselgröße ein Kriterium für das Auftreten der sprunghaften Änderung gebildet wird,
**dadurch gekennzeichnet, daß**

- die Wechselgröße (W) in einem FIR-Filter (4) mit einer Übertragungsfunktion (K) bewertet wird, die bei der Nennfrequenz ($f_N$) nicht nur selbst, sondern auch mit ihrer ersten Ableitung nach der Zeit den Wert Null als doppelte Nullstelle hat, und
- das Ausgangssignal des FIR-Filters (4) dahingehend überwacht wird, ob es einen das Auftreten einer sprunghaften Änderung der Wechselgröße (W) angebenden Schwellenwert erreicht.

2. Verfahren nach Anspruch 1,
**dadurch gekennzeichnet, daß**

- ein FIR-Filter (4) mit einer Übertragungsfunktion (K) mit einer zusätzlichen Nullstelle bei der Frequenz Null verwendet wird.

3. Schaltungsanordnung zur Durchführung des Verfahrens nach Anspruch 1,
**dadurch gekennzeichnet, daß**

- an das eingangsseitig mit der Wechselgröße (W) beaufschlagte FIR-Filter (4) ausgangsseitig ein Komparator (6) angeschlossen ist, der bei einem den Schwellenwert erreichenden Ausgangsignal des FIR-Filters (4) ein die sprunghafte Änderung der Wechselgröße (W) kennzeichnendes Ausgangssignal abgibt.

**Claims**

1. Method for detecting an abrupt change in an electrical periodic quantity, in the case of which a criterion for the occurrence of the abrupt change is formed from sampled values of the periodic quantity, **characterized in that**

- the periodic quantity (W) is evaluated in an FIR filter (4) with the aid of a transfer function (K) which at the nominal frequency ($f_N$) has the value zero as a double zero not only itself, but also with its first time derivative, and
- the output signal of the FIR filter (4) is monitored as to whether it reaches a threshold value specifying the occurrence of an abrupt change in the periodic quantity (W).

**2.** Method according to Claim 1, **characterized in that**

- use is made of an FIR filter (4) having a transfer function (K) with an additional zero at the zero frequency.

**3.** Circuit arrangement for carrying out the method according to Claim 1, **characterized in that**

- connected on the output side to the FIR filter (4) to which the periodic quantity (W) is applied on the input side is a comparator (6) which outputs an output signal characterizing the abrupt change in the periodic quantity (W) in the event of an output signal of the FIR filter (4) which reaches the threshold value.

**Revendications**

**1.** Procédé pour détecter une variation brusque d'une grandeur alternative électrique dans lequel on forme à partir des valeurs échantillonnées de la grandeur alternative un critère pour l'apparition de la variation brusque,

       **caractérisé par le fait que**

- on évalue la grandeur alternative (W) dans un filtre FIR (4) avec une fonction de transfert (K) qui, pour la fréquence nominale ($f_N$), a la valeur zéro comme double point zéro non seulement en elle-même mais aussi avec sa dérivée dans le temps, et
- on surveille le signal de sortie du filtre FIR (4) pour savoir s'il atteint une valeur de seuil indiquant l'apparition d'une variation brusque de la grandeur alternative (W).

**2.** Procédé selon la revendication 1,

       **caractérisé par le fait que**

- on utilise un filtre FIR (4) avec une fonction de transfert (K) ayant un point zéro supplémentaire à la fréquence zéro.

**3.** Circuit pour la mise en oeuvre du procédé selon la revendication 1,

       **caractérisé par le fait que**

- il est raccordé à la sortie du filtre FIR (4), recevant en entrée la grandeur alternative (W), un comparateur (6) qui, lorsque le signal de sortie du filtre FIR (4) atteint la valeur de seuil, délivre un signal de sortie caractérisant la variation brusque de la grandeur alternative (W).

FIG 1

FIG 2